## Europäisches Patentamt
## European Patent Office
## Office européen des brevets

(19)

(11) Veröffentlichungsnummer: **0 075 348**
**B1**

(12) **EUROPÄISCHE PATENTSCHRIFT**

(45) Veröffentlichungstag der Patentschrift:
**14.08.85**

(51) Int. Cl.⁴: **H 02 H 3/38**, G 01 R 31/08

(21) Anmeldenummer: **82201094.8**

(22) Anmeldetag: **06.09.82**

(54) **Verfahren und Einrichtung zur Fehlerbestimmung an elektrischen Leitungen nach dem Unterimpedanzprinzip.**

(30) Priorität: **22.09.81 CH 6094/81**

(43) Veröffentlichungstag der Anmeldung:
**30.03.83 Patentblatt 83/13**

(45) Bekanntmachung des Hinweises auf die Patenterteilung:
**14.08.85 Patentblatt 85/33**

(84) Benannte Vertragsstaaten:
**CH DE FR GB LI NL SE**

(56) Entgegenhaltungen:
**DE - A - 1 463 137**
**DE - A - 2 346 776**
**US - A - 409 269**

**PROC. IEE, Band 121, Nr. 8, August 1974, Seiten 817-825, Stevenage, G.B. L. JACKSON: "Distance-protection comparator with signal-dependent phase-angle criterion" * Figur 5 und die letzten 9 Zeilen in der linken Spalte auf Seite 819 ***

(73) Patentinhaber: **BBC Aktiengesellschaft Brown, Boveri & Cie., Haselstrasse, CH-5401 Baden (CH)**

(72) Erfinder: **De Mesmaeker, Ivan, Zeigllackerstrasse 12, CH-5200 Windisch (CH)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

# Beschreibung

Die Erfindung betrifft ein Verfahren zur Fehlerbestimmung an elektrischen Leitungen nach dem Unterimpedanzprinzip gemäss dem Oberbegriff des Anspruchs 1 sowie eine Einrichtung gemäss dem Oberbegriff des Anspruchs 5.

Ein solches Verfahren resp. eine solche Einrichtung sind bekannt, z. B. aus der Firmenschrift der BBC Aktiengesellschaft Brown, Boveri & Cie., Baden/Schweiz mit dem Titel „Statische Distanzrelais Typen LZ91, LZ92" Ausgabe Mai 1981 Nr. CH-ES 25-89 und werden als Anregung bzw. Anregeschaltung in Distanzrelais eingesetzt. Der Anregung kommt im Distanzrelais die Aufgabe zu, einen Fehler auf der Leitung, und zwar auf ihrer grössten zu überwachenden Länge zu erkennen und mittels eines Fehlersignals weitere Messeinheiten des Distanzrelais zu starten, die den gemeldeten Fehler nach Art und Entfernung identifizieren und ein selektives Abschalten des fehlerbehafteten Leitungsabschnittes veranlassen.

Je nach Eigenschaften der zu überwachenden Leitung und den zu erwartenden Fehlerarten, muss für die Unterimpedanzanregung eine speziell geeignete Auslösecharakteristik, d. h. ein Auslösebereich in der komplexen Impedanzebene festgelegt werden. In der obengenannten Literaturstelle wird ein Distanzrelais beschrieben, das als Auslösecharakteristik eine Kreisfläche verwendet. Die Prüfung, ob die Spitze des Impedanzzeigers – der Impedanz vom Relaiseinbauort bis zum Fehlerort – entsprechend einem Fehlerfall innerhalb, oder ausserhalb des Auslösebereichs liegt, lässt sich bei einer Kreischarakteristik elektronisch mit einem Phasenvergleichsverfahren durchführen, dass in der Firmenschrift CH-ES 25/90 ebenfalls beschrieben ist. Dieses Verfahren verwendet Spannungssignale, die in Amplitude- und Phasenlage den Impedanzen entsprechen. So wird mittels eines Strom/Spannungswandlers, der sekundärseitig mit einem ohmschen Widerstand belastet ist, ein Abbildspannungssignal und mittels eines Spannungswandlers ein Leitungsspannungssignal erzeugt und aus diesen sowohl ein Differenz- sowie ein Summenspannungssignal gebildet. Überschreitet die fortlaufend überwachte Phasendifferenz – der Phasenwinkel wird nach üblicher Konvention positiv gegen den Uhrzeigersinn gerechnet – zwischen dem Differenz- und dem Summenspannungssignal den Grenzwert von 90°, so liegt die Spitze des Impedanzzeigers innerhalb des Auslösekreises, der bei Verwendung der vollen Amplitude des Abbildspannungssignals zur Summenbildung im Ursprung zentriert ist. Häufig ist es jedoch von Vorteil durch eine Amplitudenmodulation des Abbildspannungssignals vor der Summenbildung einen gegen den Ursprung etwas verschobenen Auslösekreis zu verwenden. Die Grösse des Auslösekreises entspricht der Reichweite der Anregung bezüglich der Leitungslänge. Sind die zu überwachenden Leitungen lang, so muss der Radius des Auslösekreises entsprechend gross gewählt werden. Daraus ergibt sich aber die Gefahr von Fehlauslösungen, da der Auslösekreis bei grossem Radius den Wirklastbereich teilweise überdeckt. Um solche Fehlauslösungen zu vermeiden kann anstelle einer Kreischarakteristik eine linsenförmige Auslösecharakteristik verwendet werden. Eine solche – auch verschobene – linsenförmige Auslösecharakteristik ist z. B. aus der Firmenschrift der BBC Aktiengesellschaft Brown, Boveri & Cie., Baden/Schweiz mit dem Titel „Statische Distanzrelais Typ LZ96" Ausgabe November 1980 Nr. CH-ES 65-96 bekannt. Die Unterimpedanzprüfung lässt sich dann mit dem gleichen Phasenvergleichsverfahren durch Wahl eines grösseren Grenzwertes der überwachten Phasendifferenz durchführen.

Der wesentliche Nachteil der linsenförmigen Auslösecharakteristik besteht jedoch in einer ungenügenden Lichtbogenreserve an den Spitzen der Linse, d. h. für entfernt auftretende Fehler, die deshalb von der Anregung nicht erkannt werden können.

Der Erfindung liegt daher die Aufgabe zugrunde, für die gattungsgemässe Unterimpedanzanregung eine technisch einfach zu realisierende und zu überprüfende Auslösecharakteristik zu finden, die sowohl einen genügenden Sicherheitsabstand zum Wirklastbereich, als auch eine genügende Lichtbogenreserve für die entfernt liegenden Fehler aufweist.

Diese Aufgabe wird erfindungsgemäss gelöst durch die Merkmale des Verfahrensanspruchs 1 sowie durch die Merkmale des Einrichtungsanspruchs 5, d. h. durch die erfinderische und vorteilhafte Weiterbildung des beschriebenen Unterimpedanzverfahrens, indem der Grenzwert in funktionaler Abhängigkeit von einer zusätzlich bestimmten zweiten Phasendifferenz zwischen dem Leitungsspannungssignal und dem Abbildspannungssignal dynamisch eingestellt wird. Die bevorzugte Dimensionierung der Verfahrensgrössen sowie die Ausgestaltung der Einrichtung sind in den Unteransprüchen spezifiziert.

Als besonderer Vorteil der Erfindung ist anzusehen, dass die erfinderische Weiterbildung eines bewährten Unterimpedanzverfahrens die Vorzüge verschiedener Auslösecharakteristiken unter Vermeidung ihrer Nachteile miteinander verbindet.

Im folgenden wird ein Ausführungsbeispiel der Erfindung anhand von Zeichnungen erläutert. Dabei zeigt:

Fig. 1 ein Zeigerdiagramm in der komplexen Impedanz- bzw. Spannungsebene mit verschiedenen Auslösebereichen und dem Wirklastbereich,

Fig. 2 ein Blockschaltbild der Einrichtung gemäss der Erfindung, und

Fig. 3 elektrische Signale, wie sie in den Funktionseinheiten der Einrichtung wirksam sind oder erzeugt werden, in ihrer relativen Phasenlage.

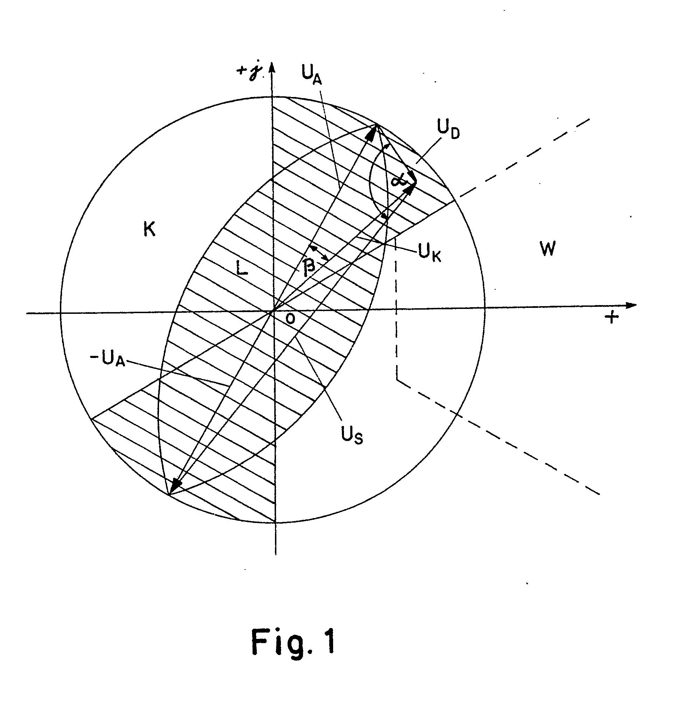

Im Zeigerdiagramm von Fig. 1 ist der Zeiger des Leitungsstroms $I_L$ entlang der positiven reellen Achse gezeichnet. Er definiert damit den Phasennullpunkt. Voreilend gegenüber dem Leitungsstrom $I_L$ sind die Zeiger des Abbildspannungssignals $U_A$ und des Leitungsspannungssignals $U_K$ gezeichnet, sowie, nach Art von Vektorpfeilen, die verschobenen Zeiger der Differenz- $U_D$ und des mit der vollen Amplitude des Abbildspannungssignals $U_A$ gebildeten Summenspannungssignals $U_S$. Das Differenz- $U_D$ und das Summenspannungssignal $U_S$ definieren bei festgelegtem Grenzwert G ihrer Phasendifferenz $\alpha$ das Auslösegebiet in der komplexen Ebene. Für einen Grenzwert G von 90° ergibt sich als Auslösegebiet die in Fig. 1 dargestellte Kreisfläche K und für 136° das linsenförmige Gebiet L. Beide Auslösecharakteristiken sind mit entscheidenden Nachteilen behaftet. So überdeckt die Kreisfläche K bei grossem Radius teilweise den Wirklastbereich W, was zu Fehlerauslösungen führt, während die Linsenfläche L dieses Problem zwar vermeidet, dafür an ihren Spitzen aber, d. h. bei entfernt liegenden Fehlern, keine genügende ohmsche Lichtbogenreserve aufweist. Durch das erfindungsgemässe dynamische Umschalten zwischen verschiedenen Auslösecharakteristiken in funktionaler Abhängigkeit von der zusätzlich bestimmten zweiten Phasendifferenz $\beta$ zwischen dem Leitungsspannungssignal $U_K$ und dem Abbildspannungssignal $U_A$ lassen sich jedoch die Vorzüge verschiedene Auslösecharakteristiken verbinden und gemeinsam ausnutzen und ihre Nachteile vermeiden. In Fig. 1 ist dies am Beispiel der Kreis- K und der Linsenfläche L dargestellt. Auf Kreischarakteristik wird immer dann umgeschaltet, wenn die zweite Phasendifferenz $\beta$ in der Umgebung von 0 oder 180° liegt und auf Linsencharakteristik ausserhalb dieser Umgebungen. Durch eine solche Kombination ergibt sich als Auslösebereich die schraffiert gekennzeichnete Fläche, die über die gesamte Leitungslänge eine genügende Lichtbogenreserve und einen ausreichenden Abstand zum Wirklastbereich W aufweist. Die Weite der Umgebungen von 0 und 180° in denen der Grenzwert G, wie in diesem Ausführungsbeispiel auf 90° eingestellt wird, ist massgeblich von der Grösse des Abbildspannungssignals $U_A$ und seiner Phasenvoreilung gegenüber dem Leitungsstrom $I_L$, oder anders ausgedrückt, von seiner Lage relativ zum Wirklastbereich W in der komplexen Ebene abhängig. Für viele zu überwachende Leitungen ergibt sich eine optimale Auslösecharakteristik in bezug auf den Wirklastbereich W, die erwünschte Reichweite der Anregung sowie in bezug auf Ausgleichsströme bei — in Mehrphasensystemen einpoligen — Kurzschlüssen, wenn die genannte Phasenvoreilung des Abbildspannungssignals $U_A$ etwa 60° beträgt und die Umgebungen von 0 und 180° etwa $\pm$30° weit sind.

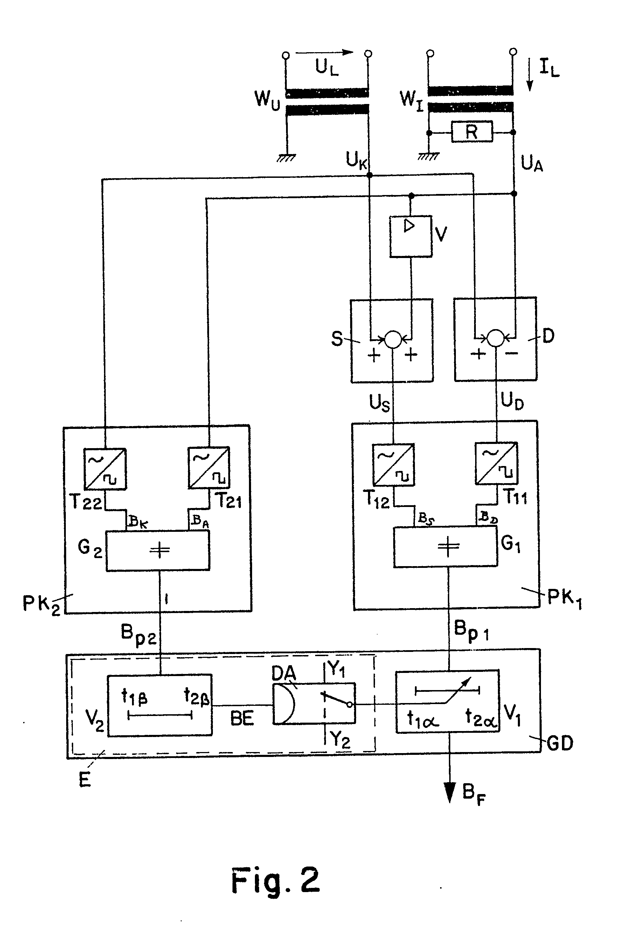

Fig. 2 zeigt das Blockschaltbild einer Einrichtung, die zur Durchführung des beschriebenen Verfahrens geeignet ist. Der Spannungswandler $W_U$ und der Strom/Spannungswandler $W_I$ sind primärseitig mit der Leitungsspannung $U_L$ und dem Leitungsstrom $I_L$ beaufschlagt — oder bei Verwendung von nicht gezeichneten zusätzlich vorgeschalteten Hauptstromwandlern, mit entsprechend transformierten Werten derselben — und sekundärseitig jeweils mit den Eingängen der Differenzstufe D und der Summenstufe S bzw. des ihr vorgeschalteten Verstärkers V, sowie den Eingängen des zweiten Phasenkomparators $Pk_2$ verbunden. Der Strom/Spannungswandler $W_I$ ist sekundärseitig darüber hinaus mit einem ohmschen Widerstand R belastet. Der erste Phasenkomparator $Pk_1$ ist eingangsseitig mit den Ausgängen der Differenzstufe D und der Summenstufe S beaufschlagt und ausgangsseitig mit dem Eingang des Grenzwertdetektors GD verbunden. Der Ausgang des zweiten Phasenkomparators $Pk_2$ ist an das Schaltungsteil E des Grenzwertdetektors GD angeschlossen, über das die Einstellung des Grenzwertes G im Grenzwertdetektor GD erfolgt.

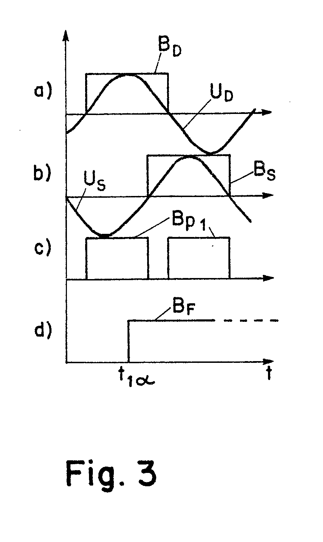

Die beiden Phasenkomparatoren $Pk_1$ oder $Pk_2$ sowie der Grenzwertdetektor lassen sich vorteilhaft mittels digitaler Elektronik aufbauen, wie dies in den entsprechenden Blöcken von Fig. 2 dargestellt ist. Dazu werden als erstes die analogen sinusförmigen Eingangssignale $U_D$, $U_S$ oder $U_A$, $U_K$ phasentreu durch die Impulsformer $T_{11}$, $T_{12}$ oder $T_{21}$, $T_{22}$ in die Binärsignale $B_D$, $B_S$ oder $B_A$, $B_K$ umgewandelt. Diese werden dann durch die Antivalenzgatter $G_1$, $G_2$ logisch verknüpft, deren Ausgangssignale $B_{P1}$ oder $B_{p2}$ in ihrer zeitlichen Länge bereits der Phasendifferenz $\alpha$ oder $\beta$ zwischen den Eingangssignalen $U_D$, $U_S$ oder $U_K$, $U_A$ entsprechen. In Fig. 3a, b und c sind die im ersten Phasenkomparator $Pk_1$ wirksamen oder erzeugten Signale in einer typischen gegenseitigen Phasenlage dargestellt, wobei das Signal $U_D$ dem Signal $U_S$ um 135° vorauseilt. Die Grenzwertüberwachung der Phasendifferenzen $\alpha$ oder $\beta$ im Grenzwertdetektor GD besteht bei einer solchen Ausführung der Phasenkomparatoren $Pk_1$ oder $Pk_2$ vorzugsweise aus den einstellbaren Verzögerungsgliedern $V_1$ oder $V_2$, die nach den Verzögerungszeiten $t_{1\alpha}$ bzw. $t_{1\beta}$ die Ausgangssignale $B_F$ bzw. BE erzeugen, vorausgesetzt, die Eingangssignale $B_{p1}$ oder $B_{p2}$ liegen zu diesem Zeitpunkt noch an. Das Signal $B_F$ ist in Fig. 3d dargestellt. Sind sie jedoch kürzer als die Zeit $t_{1\alpha}$ bzw. $t_{1\beta}$, so erscheinen am Ausgang der Verzögerungsglieder $V_1$ oder $V_2$ keine Signale, womit in einfacher Weise die Grenzwertüberwachung realisiert ist. Zur Einstellung des Grenzwerts G für den Phasenwinkel $\alpha$ über die Zeit $t_{1\alpha}$ und für den speziell in diesem Ausführungsbeispiel gewählten Fall von lediglich zwei diskreten Werten des Grenzwerts G wird das Ausgangssignal BE des zweiten Verzögerungsgliedes $V_2$ über den Digital-Analog-Wandler DA in die Spannungsstufen $Y_1$, $Y_2$ umgesetzt, welche direkt den gewünschten Werten der Verzögerungszeit $t_{1\alpha}$ und damit des Grenzwertes G entsprechen. Die Verzögerungszeiten $t_{2\alpha}$ oder $t_{2\beta}$ zur Zurücksetzung der Ausgangssignale an den Verzögerungsgliedern $V_1$ oder $V_2$ werden so eingestellt, dass das Fehlersignal $B_F$ für die nachfolgenden Messsysteme des Distanzrelais ausreichend lang ist und das Signal BE mindestens die Dauer einer halben Periode hat.

## Patentansprüche

1. Verfahren zur Fehlerbestimmung an elektrischen Leitungen nach dem Unterimpedanzprinzip,
— bei welchem jeweils ein dem Leitungsstrom ($I_L$) und der Leitungsspannung ($U_L$) am Messort proportionales Abbildspannungssignal ($U_A$) bzw. Leitungsspannungssignal ($U_K$) abgeleitet wird,
— bei welchem ein Differenzspannungssignal ($U_D$) aus dem Abbildspannungssignal ($U_A$) und dem Leitungsspannungssignal ($U_K$) gebildet wird,
— bei welchem weiter ein Summenspannungssignal ($U_S$) aus dem amplitudenmodulierten Abbildspannungssignal ($U_A$) und dem Leitungsspannungssignal ($U_K$) gebildet wird,
— bei welchem eine erste Phasendifferenz ($\alpha$) zwischen dem Differenz- ($U_D$) und dem Summenspannungssignal ($U_S$) bestimmt wird und
— bei welchem ein Fehlersignal ($B_F$) erzeugt wird, wenn die erste Phasendifferenz ($\alpha$) einen Grenzwert ($G$) überschreitet,
dadurch gekennzeichnet, dass
— eine zweite Phasendifferenz ($\beta$) zwischen dem Abbildspannungssignal ($U_A$) und dem Leitungsspannungssignal ($U_K$) bestimmt wird, und
— der Grenzwert ($G$) der ersten Phasendifferenz ($\alpha$) in funktionaler Abhängigkeit von der zweiten Phasendifferenz ($\beta$) auf mindestens zwei verschiedene Werte derart eingestellt wird, dass
— der Grenzwert ($G$) kleiner ist, wenn die zweite Phasendifferenz ($\beta$) in den Umgebungen von 0 oder 180° liegt und grösser ausserhalb dieser Umgebungen.

2. Verfahren nach Anspruch 1, dadurch gekennzeichnet, dass der Grenzwert ($G$) auf 90° eingestellt wird, wenn die zweite Phasendifferenz ($\beta$) in den Umgebungen von 0 oder 180° liegt, und auf 136° ausserhalb dieser Umgebungen.

3. Verfahren nach Ansprüchen 1 und 2, dadurch gekennzeichnet, dass die Umgebung von 0° von −30 bis +30° und die Umgebung von 180° sich von 150 bis 210° erstreckt.

4. Verfahren nach Anspruch 1, dadurch gekennzeichnet, dass das Abbildspannungssignal ($U_A$) dem Leitungsstrom ($I_L$) um 60° voreilt.

5. Einrichtung zur Fehlerbestimmung an elektrischen Leitungen nach dem Unterimpedanzprinzip,
— bei welcher ein Strom/Spannungswandler ($W_I$) und ein Spannungswandler ($W_U$) primärseitig mit dem Leitungsstrom ($I_L$) und der Leitungsspannung ($U_L$) beaufschlagt sind,
— bei welcher der Strom/Spannungswandler ($W_I$) sekundärseitig mit einem ohmschen Widerstand ($R$) belastet ist,
— bei welcher der Strom/Spannungswandler ($W_I$) und der Spannungswandler ($W_U$) sekundärseitig jeweils mit den Eingängen einer Differenzstufe ($D$) und einer Summierstufe ($S$) verbunden sind, wobei zwischen dem einen Eingang der Summierstufe ($S$) und dem Ausgang des Strom/Spannungswandlers ($W_I$) ein Verstärker ($V$) geschaltet ist,
— bei welcher ein erster Phasenkomparator ($Pk_1$) eingangsseitig mit den Ausgängen der Differenzstufe ($D$) und der Summierstufe ($S$) beaufschlagt und ausgangsseitig mit dem Eingang eines Grenzwertdetektors ($GD$) verbunden ist,
dadurch gekennzeichnet, dass
— der Strom/Spannungswandler ($W_I$) und der Spannungswandler ($W_U$) sekundärseitig mit den

Eingängen eines zweiten Phasenkomparators ($Pk_2$) verbunden sind und dass
— eine Wirkverbindung zwischen dem Ausgang des zweiten Phasenkomparators ($Pk_2$) und einem Schaltungsteil ($E$) des Grenzwertdetektors ($GD$) besteht zur Einstellung des Grenzwertes ($G$) im Grenzwertdetektor ($GD$).

6. Einrichtung nach Anspruch 5, dadurch gekennzeichnet, dass der Grenzwertdetektor ($GD$) ein erstes Verzögerungsglied ($V_1$) mit einstellbarer Verzögerung und das Schaltungsteil ($F$) des Grenzwertdetektors ($GD$) ein zweites Verzögerungsglied ($V_2$) aufweist dem ein Digital-Analog-Wandler ($D_A$) nachgeschaltet ist, dessen Ausgang mit dem ersten einstellbaren Verzögerungsglied ($V_1$) zur Einstellung der Verzögerungszeit ($t_{1\alpha}$) in Wirkverbindung steht.

## Claims

1. Method for finding faults in electric lines according to the principle of underimpedance,
— in which method in each case a representative voltage signal ($U_A$) and a line voltage signal ($U_K$) are derived which are proportional to the line current ($I_L$) and to the line voltage ($U_L$), respectively, at the measuring location,
— in which method a differential voltage signal ($U_D$) is formed from the representative voltage signal ($U_A$) and the line voltage signal ($U_K$),
— in which method also a sum voltage signal ($U_S$) is formed from the amplitude-modulated representative voltage signal ($U_A$) and the line voltage signal ($U_K$),
— in which method a first phase difference ($\alpha$) between the differential ($U_D$) and the sum voltage signal ($U_S$) is determined, and
— in which method a fault signal ($B_F$) is generated when the first phase difference ($\alpha$) exceeds a limit value ($G$),
characterised in that
— a second phase difference ($\beta$) between the representative voltage signal ($U_A$) and the line voltage signal ($U_K$) is determined, and
— the limit value ($G$) of the first phase difference ($\alpha$) is adjusted, in functional dependence on the second phase difference ($\beta$), to at least two different values in such a manner that
— the limit value ($G$) is smaller when the second phase difference ($\beta$) lies in the vicinities of 0 or 180° and is larger outside these vicinities.

2. Method according to Claim 1, characterised in that the limit value ($G$) is set to 90° when the second phase difference ($\beta$) lies in the vicinities of 0 or 180°, and to 136° outside these vicinities.

3. Method according to Claims 1 and 2, characterised in that the vicinity of 0 extends from −30 to +30° and the vicinity of 180° extends from 150 to 210°.

4. Method according to Claim 1, characterised in that the representative voltage signal ($U_A$) leads the line current ($I_L$) by 60°.

5. Device for finding faults in electric lines according to the principle of underimpedance,

— in which device the line current ($I_L$) and the line voltage ($U_L$) are applied to the primary of a current/voltage transformer ($W_I$) and of a voltage transformer ($W_U$),

— in which device the secondary of the current/voltage transformer ($W_I$) is loaded with a resistive impedance (R),

— in which device the secondary of the current/voltage transformer ($W_I$) and of the voltage transformer ($W_U$) are in each case connected to the inputs of a differential stage (D) and of a summing stage (S), an amplifier (V) being connected between one input of the summing stage (S) and the output of the current/voltage transformer ($W_I$),

— in which device the inputs of a first phase comparator ($Pk_1$) are connected to the outputs of the differential stage (D) and of the summing stage (S) and the output is connected to the input of a limit-value detector (GD),

characterised in that

— the secondaries of the current/voltage transformer ($W_I$) and of the voltage transformer ($W_U$) are connected to the inputs of a second phase comparator ($Pk_2$) and that

— an effective connection exists between the output of the second phase comparator ($Pk_2$) and a circuit section (E) of the limit-value detector (GD) for adjusting the limit value (G) in the limit-value detector (GD).

6. Device according to Claim 5, characterised in that the limit-value detector (GD) is provided with a first delay section ($V_1$) having an adjustable delay and the circuit section (E) of the limit-value detector (GD) is provided with a second delay section ($V_2$) which is followed by a digital/analog converter ($D_A$) the output of which is effectively connected to the first adjustable delay section ($V_1$) for adjusting the delay time ($t_{1\alpha}$).

**Revendications**

1. Procédé pour la détermination de défauts dans des lignes électriques d'après le principe de subimpédance, pour lequel:

— un signal de tension d'image ($U_A$) ou un signal de tension de ligne ($U_K$) proportionnel au courant de ligne ($I_L$) et à la tension de ligne ($U_L$) à l'endroit de mesure est chaque fois dérivé,

— un signal de tension de différence ($U_D$) est formé à partir du signal de tension d'image ($U_A$) et du signal de tension de ligne ($U_K$),

— un signal de tension de somme ($U_S$) est, en outre, formé à partir du signal de tension d'image ($U_A$) modulé en amplitude et du signal de tension de ligne ($U_K$),

— une première différence de phases ($\alpha$) est déterminée entre le signal de tension de différence ($U_D$) et le signal de tension de somme ($U_S$), et

— un signal de défaut ($B_F$) est produit lorsque la première différence de phases ($\alpha$) dépasse par excès une valeur limite (G),

caractérisé en ce que

— une deuxième différence de phases ($\beta$) entre le signal de tension d'image ($U_A$) et le signal de tension de ligne ($U_K$) est déterminée, et

— la valeur limite (G) de la première différence de phases ($\alpha$) est réglée en dépendance fonctionnelle de la seconde différence de phases ($\beta$) sur au moins deux valeurs différentes d'une manière telle que

— la valeur limite (G) soit plus petite lorsque la seconde différence de phases ($\beta$) se situe dans le voisinage de 0 ou de 180° et soit plus grande en dehors de ces voisinages.

2. Procédé suivant la revendication 1, caractérisé en ce que la valeur limite (G) est réglée sur 90° lorsque la seconde différence de phases ($\beta$) se situe dans les voisinages de 0 ou de 180° et sur 136° en dehors de ces voisinages.

3. Procédé suivant les revendications 1 et 2, caractérisé en ce que le voisinage de 0° va de $-30$ à $+30°$ et le voisinage de 180° va de 150 à 210°.

4. Procédé suivant la revendication 1, caractérisé en ce que le signal de tension d'image ($U_A$) précède le courant de lignes ($I_L$) de 60°.

5. Dispositif pour la détermination de défauts dans des lignes électriques d'après le principe de subimpédance, pour lequel

— un transformateur de courant/tension ($W_I$) et un transformateur de tension ($W_U$) sont alimentés du côté de leur primaire par le courant de ligne ($I_L$) et par la tension de ligne ($U_L$),

— le transformateur de courant/tension ($W_I$) est chargé, du côté de son secondaire, par une résistance ohmique (R),

— le transformateur de courant/tension ($W_I$) et le transformateur de tension ($W_U$) sont connectés du côté de leur secondaire chacun aux entrées d'un étage de différence (D) et d'un étage de sommation (S), un amplificateur (V) étant connecté entre la première entrée de l'étage de sommation (S) et la sortie du transformateur de courant/tension ($W_I$),

— un premier comparateur de phases ($Pk_1$) est alimenté du côté de son entrée par les sorties de l'étage de différence (D) et de l'étage de sommation (S) et est connecté du côté de sortie à l'entrée d'un détecteur de valeur limite (GD),

caractérisé en ce que

— le transformateur de courant/tension ($W_I$) et le transformateur de tension ($W_U$) sont connectés du côté de leur secondaire aux entrées d'un second comparateur de phases ($Pk_2$), et

— une connexion active entre la sortie du second comparateur de phases ($Pk_2$) et un montage (E) du détecteur de valeur limite (GD) existe pour régler la valeur limite (G) dans le détecteur de valeur limite (GD).

6. Dispositif suivant la revendication 5, caractérisé en ce que le détecteur de valeur limite (GD) présente un premier élément à retard ($V_1$) présentant un retard réglable et le montage (E) du détecteur de valeur limite (GD) présente un second élément à retard ($V_2$) qui est suivi d'un convertisseur numérique-analogique ($D_A$), dont la sortie est connectée activement au premier élément à retard réglable ($V_1$) pour régler la durée de retard ($t_{1\alpha}$).

Fig. 1

7

Fig. 2

Fig. 3